(19) Europäisches Patentamt
European Patent Office
Office européen des brevets

(11) **EP 2 393 128 A1**

(12) **EUROPEAN PATENT APPLICATION**

(43) Date of publication:
**07.12.2011 Bulletin 2011/49**

(51) Int Cl.:
***H01L 33/00*** (2010.01)   ***H01L 33/44*** (2010.01)

(21) Application number: **10178705.9**

(22) Date of filing: **23.09.2010**

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**
Designated Extension States:
**BA ME RS**

(30) Priority: **03.06.2010 JP 2010127506**

(71) Applicant: **Kabushiki Kaisha Toshiba
Tokyo (JP)**

(72) Inventors:
• **Akimoto, Yosuke
Tokyo (JP)**

• **Togawa, Ryuichi
Tokyo (JP)**
• **Kojima, Akihiro
Tokyo (JP)**
• **Iduka, Miyuki
Tokyo (JP)**
• **Sugizaki, Yoshiaki
Tokyo (JP)**

(74) Representative: **HOFFMANN EITLE
Patent- und Rechtsanwälte
Arabellastraße 4
81925 München (DE)**

(54) **Method for manufacturing light-emitting device and light-emitting device manufactured by the same**

(57)    A method for manufacturing a light-emitting device (110,111,120,130) is disclosed. The method includes removing a substrate (10) from a semiconductor layer (5). The semiconductor layer (5) is provided on a first main surface (10a) of the substrate (10). The semiconductor layer (5) includes a light-emitting layer (33). At least a top surface (5a) and side surfaces (5b) of the semiconductor layer (5) are covered with a first insulating film (13). A first electrode portion (14) and a second electrode portion (15) electrically continuous to the semiconductor layer (5) are provided. The first insulating film (13) is covered with a second insulating film (16). The removing is performed by irradiating the semiconductor layer (5) with laser light (LSR) from a side of a second main surface (10b) of the substrate (10). The second main surface (10b) is opposite to the first main surface (10a). Each of band-gap energy of the second insulating film (16) and band-gap energy of the semiconductor layer (5) are smaller than energy of the laser light (LSR). Also a light-emitting device is disclosed which can be produced using the method of manufacturing.

FIG. 12

EP 2 393 128 A1

**Description**

FIELD

Embodiments described herein relate generally to a method for manufacturing a light-emitting device and a light-emitting device manufactured by the same.

BACKGROUND

The applications of light-emitting devices have expanded to lighting apparatuses, back-light sources for image-displaying apparatuses, displaying apparatuses, and the like.

In recent years, light-emitting devices smaller in size have been demanded. In a manufacturing method proposed to enhance mass productivity, a semiconductor layer including a light-emitting layer is formed on a substrate by crystal growth, then the substrate is removed from the semiconductor layer by laser-light irradiation, and thereafter the resultant semiconductor layer is divided into multiple devices.

In the process of removing the substrate from the semiconductor layer by the laser-light irradiation, the laser light enters an insulating film that covers the semiconductor layer, and the energy of the laser light heats not only the side surfaces of the semiconductor layer but also electrodes.

BRIEF DESCRIPTION OF THE DRAWINGS

FIG. 1 is a flowchart of a method for manufacturing a light-emitting device according to a first embodiment;

FIG. 2 is a schematic plan view of a method for manufacturing a light-emitting device according to this embodiment in a wafer configuration;

FIGS. 3A to 8 are schematic cross-sectional views of the method for manufacturing a light-emitting device according to the first embodiment;

FIGS. 9 and 10 are schematic cross-sectional views of another example of the method for manufacturing a light-emitting device according to the first embodiment;

FIGS. 11A to 13 are schematic cross-sectional views of a method for manufacturing a light-emitting device according to a second embodiment;

FIGS. 14A to 16 are schematic cross-sectional views of a method for manufacturing a light-emitting device according to a third embodiment;

FIG. 17 is a schematic cross-sectional view of a light-emitting device according to a fourth embodiment;

FIG. 18 is an enlarged cross-sectional view of the relevant part in FIG. 17;

FIG. 19 is a schematic cross-sectional view of a light-emitting device according to a fifth embodiment;

FIG. 20 is a schematic cross-sectional view of a light-emitting device according to a sixth embodiment; and

FIG. 21 is a schematic cross-sectional view of a light-emitting device according to a seventh embodiment.

DETAILED DESCRIPTION

In general, according to one embodiment, a method for manufacturing a light-emitting device is disclosed. The method can include removing a substrate from a semiconductor layer. The semiconductor layer is provided on a first main surface of the substrate. The semiconductor layer includes a light-emitting layer. At least a top surface and side surfaces of the semiconductor layer are covered with a first insulating film. A first electrode portion electrically continuous to the semiconductor layer is provided. A second electrode portion electrically continuous to the semiconductor layer is provided. The first insulating film is covered with a second insulating film. The removing is performed by irradiating the semiconductor layer with laser light from a side of a second main surface of the substrate. The second main surface is opposite to the first main surface. Each of band-gap energy of the second insulating film and band-gap energy of the semiconductor layer are smaller than energy of the laser light.

According to another embodiment, a light-emitting device includes a semiconductor layer, a first electrode portion and a second electrode portion, a first insulating film and a second insulating film. The semiconductor layer includes a light-emitting layer. The first electrode portion and the second electrode portion are provided on a second main surface of the semiconductor layer, and the second main surface is opposite to a first main surface of the semiconductor layer. The first insulating film covers at least side surfaces of the semiconductor layer and the second insulating film covers the first insulating film. A thickness of a part of the first insulating film is smaller than 248 nm. The second insulating film and the semiconductor layer are made of materials which absorb a laser light. The laser light has a wavelength longer than 248 nm.

Some embodiments of the invention will be described below with reference to the drawings.

The drawings are only schematic or conceptual ones. The relationship between the thickness and the width of each portion, the size ratio between of portions, or the like are not necessarily the same as those in the actual ones. In addition, a portion may be shown with different dimensions or different size ratios between the drawings.

In addition, in the description and the drawings, the same element as that described with reference to a preceding drawing are assigned the same reference numerals, and the detailed description thereof is omitted herein.

First Embodiment

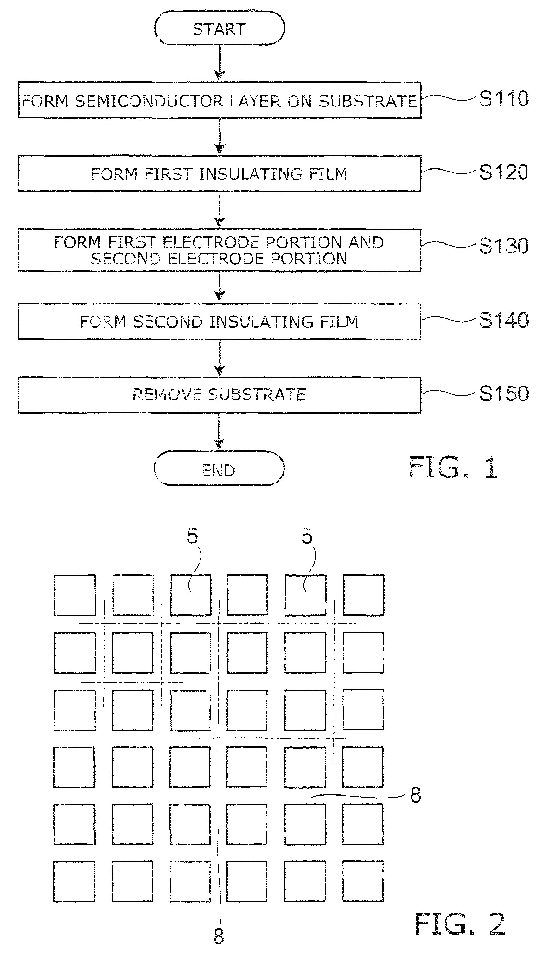

FIG. 1 is a flowchart describing a method for manufacturing a light-emitting device according to a first embodiment.

As shown in FIG. 1, the method for manufacturing a light-emitting device according to the first embodiment includes a process of forming a semiconductor layer on a substrate (step S110), a process of forming a first insulating film (step S120), a process of forming a first electrode and a second electrode (step S130), a process of forming a second insulating film (step S140), and a process of removing the substrate (step S150).

In step S110, a semiconductor layer including a light-emitting layer (active layer) is formed on a first main surface of a substrate.

In step S120, a first insulating film is formed to cover at least the top surface of and the side surfaces of the semiconductor layer that has been formed on the substrate.

In step S130, a first electrode portion and a second electrode portion are formed so as to be electrically continuous to the semiconductor layer.

In step S140, a second insulating film is covered with the first insulating film,

In step S150, a second main surface of the substrate, which is on the opposite side to the first main surface, is irradiated with laser light, and the substrate is removed from the semiconductor layer.

In the manufacturing method of this embodiment, both the band-gap energy of the second insulating film and that of the semiconductor layer are smaller than the energy of the laser light. In addition, in this embodiment, portions of the first insulating film cover the side surfaces of the semiconductor layer, and that portions suppress the advancing of the laser light emitted to remove the substrate. To put it differently, the laser light cannot progress so deeply as to reach the light-emitting layer on the side-surfaces of the semiconductor layer from the first main surface in the first insulating film covering the side surfaces of the semiconductor layer.

The first insulating film covering the side surfaces of the semiconductor layer suppresses the advancing of the laser light emitted to remove the substrate and thus effects on the side-surface portions of the semiconductor layer by irradiation with the laser light are reduced. To be more specific, the laser-light irradiation onto the side surfaces of the semiconductor layer heats the side-surface portions, resulting in the degradation of the characteristics. In this embodiment, the side surfaces of the semiconductor layer are irradiated with no laser light, so that the degradation of the semiconductor layer by the heating can be prevented. In particular, the degradation of the light-emitting layer included in the semiconductor layer can be avoided. Consequently, the stable light-emitting characteristics are maintained. In addition, laser-light irradiation onto the side surfaces of the semiconductor layer may cause removal of the first insulating film at the interface, but the removal of the first insulating film at this interface can also be avoided in this embodiment.

The portion of the first insulating film covering the side surfaces of the semiconductor layer can suppress the advancing of the laser light, provided that any of the following two conditions is satisfied:

(1) Firstly, at least part of the portions of the first insulating film that cover the respective side surfaces of the semiconductor layer between the first main surface and the light-emitting layer has a smaller thickness, in a direction perpendicular to the side surfaces, than a wavelength of the laser light.

(2) Secondly, the band-gap energy of the first insulating film is smaller than the energy of the laser light.

If any of the conditions (1) and (2) is satisfied, the advancing of the laser light in the first insulating film that covers the side surfaces of the semiconductor layer is blocked, or is made more difficult. Accordingly, the laser light cannot reach the position of the light-emitting layer on the side-surfaces of the semiconductor layer from the first main surface of the substrate. Consequently, the effects on the side-surface of the semiconductor layer is reduced.

Subsequently, a specific method for manufacturing a light-emitting device will be described with reference to FIGS. 2 to 8.

FIG. 2 is a schematic plan view illustrating a method for manufacturing a light-emitting device according to this embodiment in a wafer configuration.

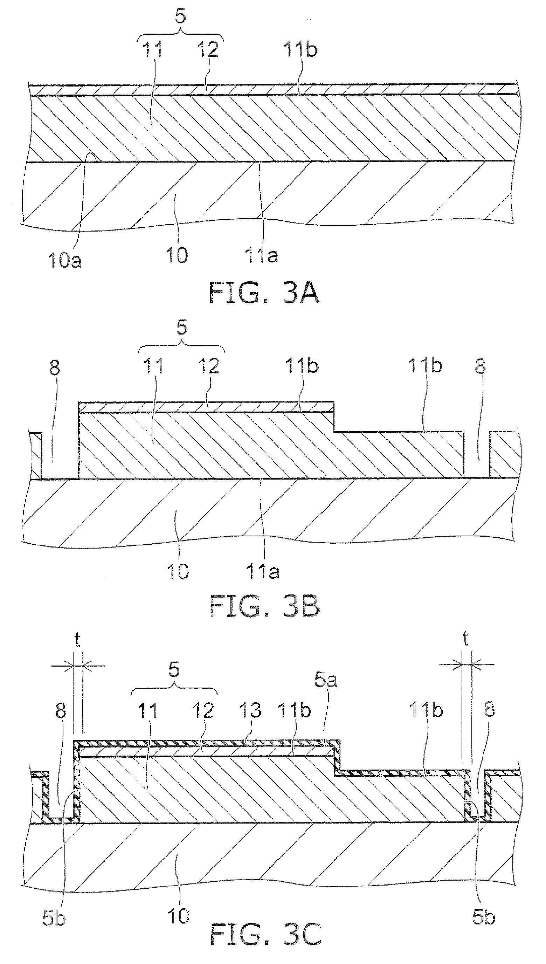

FIGS. 3A to 8 are schematic cross-sectional views describing sequentially the method for manufacturing a light-emitting device.

The method for manufacturing a light-emitting device of this specific example satisfies the first condition (1).

Firstly, as shown in FIG. 3A, a first semiconductor layer 11 is formed on a first main surface 10a of a substrate 10. The first semiconductor layer 11 includes a first main surface 11a that is a surface on the substrate 10 side. Next, the first semiconductor layer 11 includes a second main surface 11b that is a surface opposite to the first main surface 11a. A second semiconductor layer 12 is formed on the second main surface 11b. If the light-emitting layer is made, for example, of a nitride semiconductor, the laminate of the first semiconductor layer 11 and the second semiconductor layer 12 (a semiconductor layer 5) can be formed by a crystal growth on a sapphire substrate. As an example, gallium nitride (GaN) is used for both the first semiconductor layer 11 and second semiconductor layer 12.

Subsequently, a part of the second semiconductor layer 12 and a part of the first semiconductor layer 11 are selectively removed by, for example, reactive ion etching (RIE) method using unillustrated resist. Consequently, as shown in FIG. 3B, a recessed portion and a projected portion are formed on the side of the second main surface 11b of the first semiconductor layer 11. The recessed portion corresponds to the portion where a part of the second semiconductor layer 12 and a part of the first semiconductor layer 11 are removed, whereas the projected portion corresponds to the portion where the second semiconductor layer 12 including the light-emitting layer remains unremoved. The second main surface 11b of the first semiconductor layer 11 is exposed from the bottom portion of the recessed portion.

Grooves 8 are formed so as to pierce the semiconductor layer 5 and reach the substrate 10. The grooves 8 sub-divide the semiconductor layer 5 into plural sections on the substrate 10. For example, as shown in FIG. 2, the grooves 8 are formed in a lattice shape within a wafer plane. Consequently, each of the individual sections of the semiconductor layer 5 is surrounded by the grooves 8.

Subsequently, as shown in FIG. 3C, a first insulating film 13 covers the exposed portion of the second main surface 11b of the first semiconductor layer 11, the entire surface of the second semiconductor layer 12, and the inner surfaces of the grooves 8. The first insulating film 13 is formed by, for example, a chemical vapor deposition (CVD) method. The first insulating film 13 is made, for example, of silicon oxide ($SiO_2$). The first insulating film 13 covers at least a top surface 5a and side surfaces 5b of the semiconductor layer 5.

In this embodiment, portions of the first insulating film 13 that cover the side surfaces 5b of the semiconductor layer 5 are provided to reach the first main surface 10a of the substrate 10. In addition, in the formation of the first insulating film 13 in this embodiment, the thickness t (the thickness measured in the direction perpendicular to the side surfaces 5b) of each of the portions of the first insulating film 13 covering the side surfaces 5b of the semiconductor layer 5 is smaller than the wavelength of the laser light to be used to remove the substrate 10.

The laser light to be used is, for example, light of ArF laser (wavelength: 193 nm), light of KrF laser (wavelength: 248 nm), light of XeCl laser (wavelength: 308 nm), or light of XeF laser (wavelength: 353 nm). The first insulating film 13 is formed to have the thickness t smaller than the wavelength of the laser light that is to be used actually.

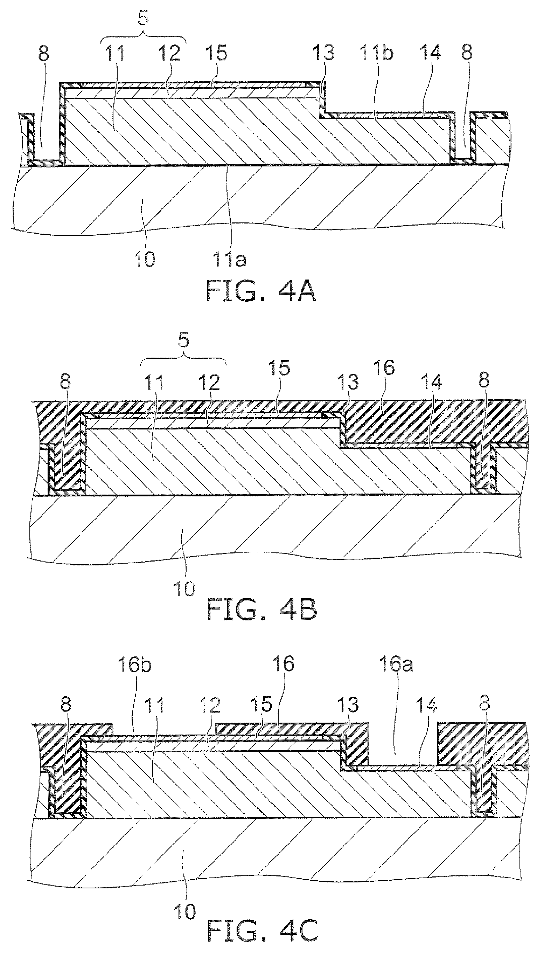

Subsequently, openings are selectively formed in the first insulating film 13. As shown in FIG. 4A, a p-side electrode (second electrode) 15 is formed on the second semiconductor layer 12 of the projected portion, and an n-side electrode (first electrode) 14 is formed on the second main surface 11b of the first semiconductor layer 11 of the recessed portion.

Subsequently, as shown in FIG. 4B, a second insulating film 16 is formed to cover the n-side electrode 14, the p-side electrode 15, and the first insulating film 13. In addition, the second insulating film 16 is buried into the grooves 8. The second insulating film 16 is made, for example, of silicon nitride, silicon oxide, or a resin such as polyimide.

After the formation of the second insulating film 16, both an opening 16a that reaches the n-side electrode 14 and an opening 16b that reaches the p-side electrode 15 are formed in the second insulating film 16 as shown in FIG. 4C with, for example, a solution of hydrofluoric acid.

Subsequently, seed metal (not illustrated) is formed on the top surface of the second insulating film 16 as well as on the inner walls (the side surfaces and bottom surfaces) of the opening 16a and the opening 16b, and then resist for plating (not illustrated) is formed, and, after that, a Cu plating process is performed with the seed metal used as a current pathway. The seed meal contains Cu, for example.

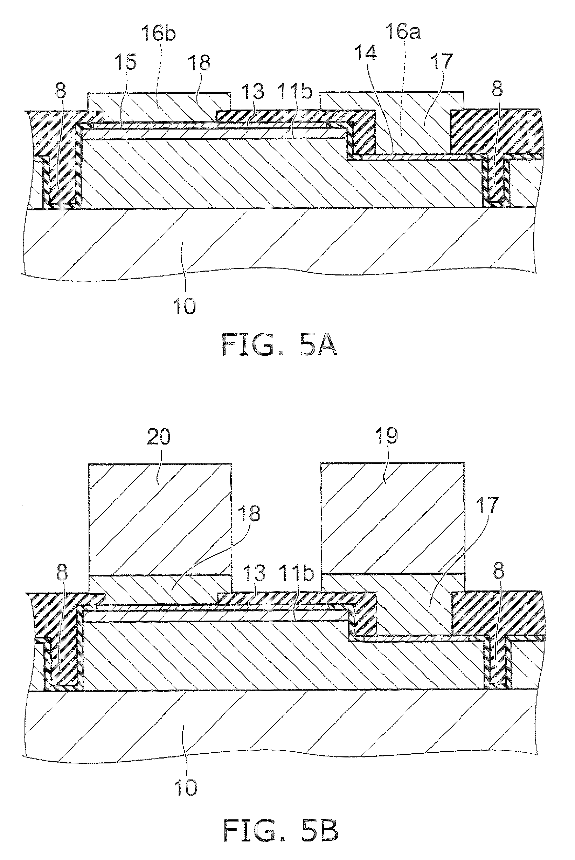

Consequently, as shown in FIG. 5A, an n-side interconnection 17 and a p-side interconnection 18 are selectively formed on the top surface of the second insulating film 16 (i.e., the surface of the second insulating film 16 on the opposite side to the first semiconductor layer 11 and the second semiconductor layer 12). The n-side interconnection 17 is formed also in the opening 16a, and is connected to the n-side electrode 14. The p-side interconnection 18 is formed also in the opening 16b, and is connected to the p-side electrode 15.

Subsequently, after the resist for plating that has been used in the plating of the n-side interconnection 17 and of the p-side interconnection 18 is removed using a chemical solution, other resist for plating for forming metal pillars is formed and a process of electrolytic plating is performed with the seed metal mentioned above used as a current pathway. Thus, as shown in FIG. 5B, an n-side metal pillar 19 is formed on the n-side interconnection 17 whereas a p-side metal pillar 20 is formed on the p-side interconnection 18.

After that, the resist for forming metal pillars is removed using a chemical solution, and then exposed portions of the seed metal are removed. Consequently, the electric connection between the n-side interconnection 17 and the p-side interconnection 18 through the seed metal is cut off.

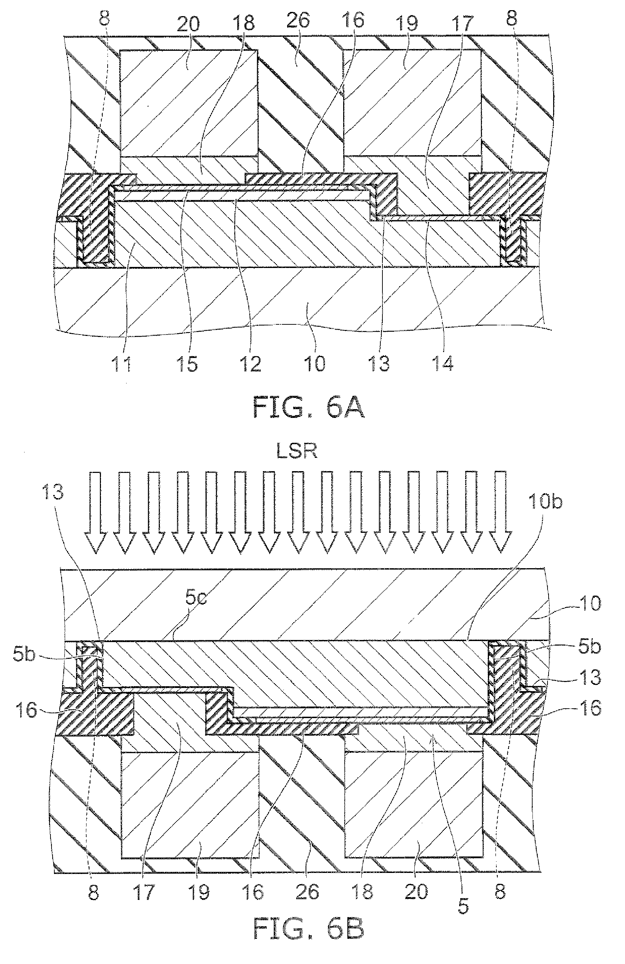

Subsequently, as shown in FIG. 6A, the n-side interconnection 17, the p-side interconnection 18, the n-side metal pillar 19, the p-side metal pillar 20, and the second insulating film 16 are covered with a resin (third insulating film) 26. The resin 26 reinforces the semiconductor layer 5, the n-side metal pillar 19, and the p-side metal pillar 20. The resin 26 is made, for example, of, an epoxy resin, a silicone resin, or a fluorine resin. The resin 26 is colored in black, for example. The resin 26 thus prevents the internal light from leaking out and prevents unnecessary external light from entering.

Subsequently, as shown in FIGS. 6B to 7, a process of laser lift off (LLO) is performed to remove the substrate 10 from the semiconductor layer 5. Each of the drawings in FIGS. 6B to 7 shows the structure shown in FIG. 6A upside down.

Laser light LSR to be used is, for example, light of ArF laser (wavelength: 193 nm), light of KrF laser (wavelength: 248 nm), light of XeCl laser (wavelength: 308 nm), or light of XeF laser (wavelength: 353 nm).

The laser light LSR is thrown upon the semiconductor layer 5 from the side of a second main surface 10b (the opposite side to the first main surface 10a) of the substrate 10 towards the semiconductor layer 5. The laser light LSR passes through the substrate 10, and reaches a lower surface 5c of the semiconductor layer 5. The second insulating film 16 (irrespective of silicon nitride or a resin) and the semiconductor layer 5 absorb the laser light LSR. The second insulating film 16 and the semiconductor layer 5 are made of materials which absorb the laser light LSR having a wavelength longer than 248 nm. Alternatively, the band-gap energy of the second insulating film 16 and the band-gap energy of the semiconductor layer 5 are smaller than the energy of the laser light LSR. Consequently, the laser light LSR that has passed through the substrate 10 is absorbed by the semiconductor layer 5 and the second insulating film 16. In the meanwhile, at the interface of the substrate 10 and semiconductor layer 5, the absorption of the laser light LSR causes the GaN component in the semiconductor layer 5 to be thermally decomposed in a manner shown in the following reaction formula, for example.

$$GaN \rightarrow Ga + (1/2) N_2 \uparrow$$

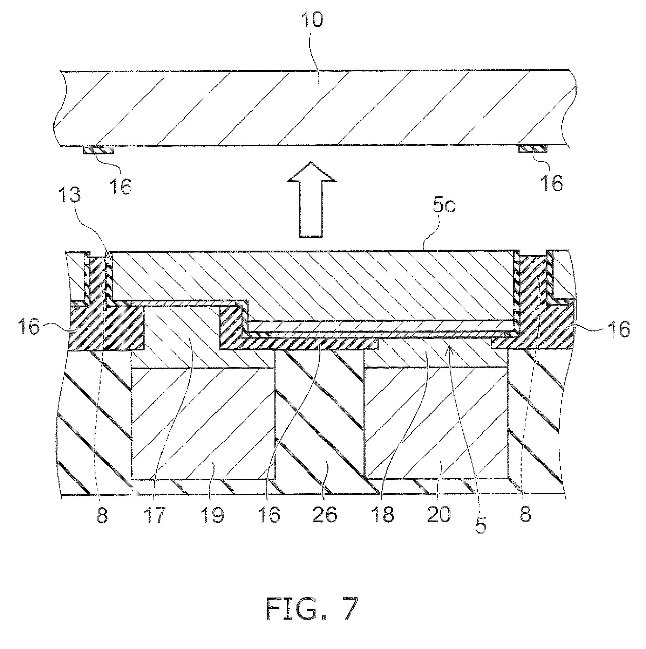

Consequently, as shown in FIG. 7, the substrate 10 is removed from the semiconductor layer 5.

In this embodiment, the thickness t of the first insulating film 13 covering the side surfaces 5b of the semiconductor layer 5 is smaller than the wavelength of the laser light LSR. Accordingly, the diffraction limit of the laser light LSR prevents the entry of the laser light LSR into the inside (inside of the first insulating film 13) from the end surfaces of the portions of the first insulating film 13 on the side of a lower surface 5c of and covering the side surfaces 5b of the semiconductor layer 5.

If the thickness t of the first insulating film 13 is equal to or larger than the wavelength of the laser light LSR, the laser light LSR enters the first insulating film 13. In contrast, if the thickness t of the first insulating film 13 is smaller than the wavelength of the laser light LSR, the diffraction limit of the laser light LSR suppresses drastically the entry of the laser light LSR into the first insulating film 13.

If the entry of the laser light LSR is suppressed in this way, the degradation of the semiconductor layer 5, especially, that of the light-emitting layer of the second semiconductor layer 12, is avoided. Consequently, stable light-emitting characteristics can be maintained. In addition, removal of the first insulating film 13 is prevented from occurring at the interface between each of the side surfaces 5b of the semiconductor layer 5 and the first insulating film 13. In addition, the effects of the irradiation of the laser light LSR on the second insulating film 16 that is in contact with the first insulating film 13 near the side surfaces 5b, such as the melting of the second insulating film 16, can be reduced. Consequently, the lowering of the reliability is suppressed.

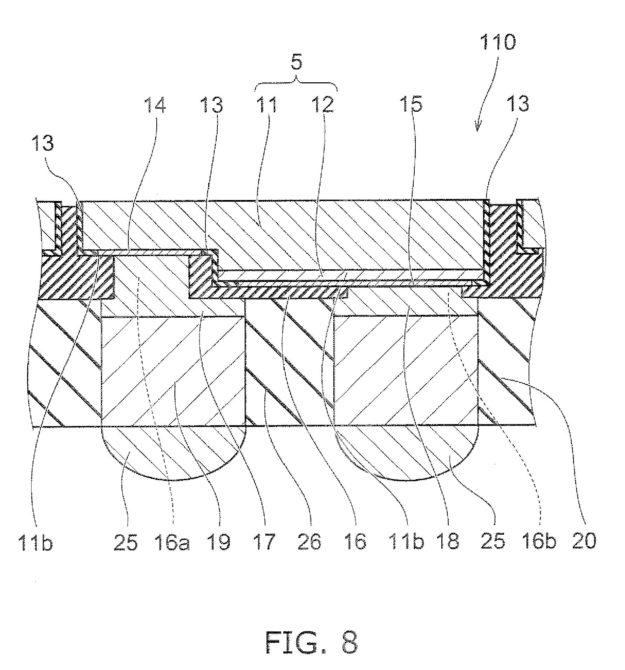

After that, as shown in FIG. 8, the surface of the resin 26 is ground until the end surfaces of the n-side metal pillar 19 and the p-side metal pillar 20 are exposed. Then, if necessary, external terminals 25, such as solder balls or metal bumps, are provided on the exposed end surfaces. A light-emitting device 110 is thus completed.

Since the use of this manufacturing method allows the light-emitting device 110 to be built at the wafer level, CSP (Chip Size Package) of the light-emitting device 110, whose size is as small as the size of the bare chip, can be provided easily. In addition, after building at the wafer level, the light-emitting devices 110 may be completed by dicing into individuals. The cutting method is, for example, the mechanical machining using a diamond blade or the like, the cutting by laser irradiation, or the cutting by high-pressured water.

Subsequently, description will be given of another example of the method for manufacturing a light-emitting device according to the first embodiment.

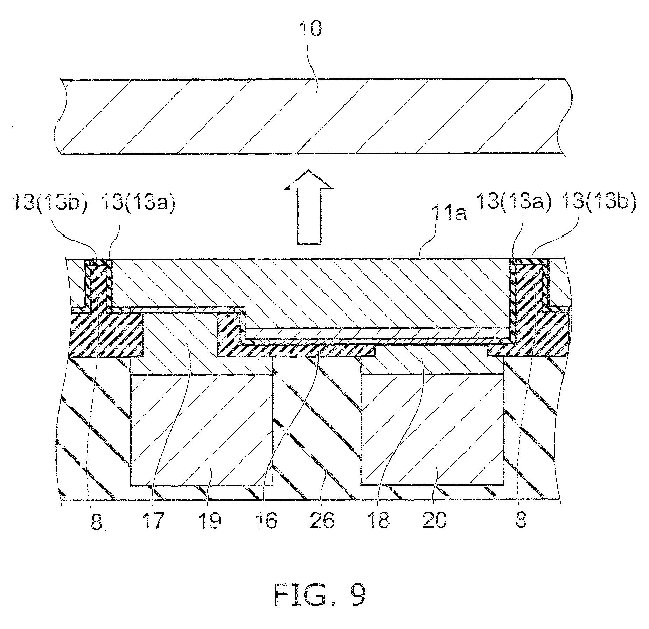

FIGS. 9 to 10 are schematic cross-sectional views describing sequentially the another example of the method for manufacturing a light-emitting device according to the first embodiment.

The method for manufacturing a light-emitting device of this specific example satisfies the second condition (2) mentioned above.

Specifically, the first insulating film 13 made of a material whose band-gap energy is smaller than the energy of the laser light LSR is used. For example, the first insulating film 13 is made of a material containing a nitride, or, to be more specific, a material containing silicon nitride, for example.

In this example, the processes from the formation of the first semiconductor layer 11 and the second semiconductor layer 12 until the laser lift off are similar to those shown in FIGS. 3A to 6.

Since the first insulating film 13 is made of a material whose band-gap energy is smaller than the energy of the laser light LSR, there is no limit to the thickness t of the first insulating film 13 on the side surfaces 5b of the semiconductor layer 5. If the band-gap energy of the first insulating film 13 is smaller than the energy of the laser light LSR, the transmissibility of the laser light LSR drops significantly. Consequently, the entry, into the first insulating film 13, of the laser light LSR thrown upon at the laser lift off is suppressed.

The energy of the laser light LSR is calculated by the following formula.

$$E = h \times (c / \lambda)$$

where E is the energy, h is the Planck's constant, c is the speed of light, and A is the wavelength.

If, for example, light of the KrF laser (wavelength: 248 nm) is used as the laser light LSR, the energy is approximately 5.0 eV. In this case, the material to be used for the first insulating film 13 has band-gap energy that is smaller than 5.0 eV. For example, silicon nitride (SiN) is used. Note that the band-gap energy of the silicon nitride (SiN) varies depending on the composition ratio of Si and N. Accordingly, the silicon nitride to be used may be one with a composition ratio that makes the band-gap energy smaller than 5.0 eV.

FIG. 9 illustrates a state where the substrate is removed by the laser lift off.

As shown in FIG. 9, if the first insulating film 13 is made of silicon nitride (SiN), the laser light LSR does not enter the first insulating film 13a covering the side surfaces 5b of the semiconductor layer 5, and thus the degradation of both the side surfaces 5b of the semiconductor layer 5 and the second insulating film 16 is suppressed.

In the meanwhile, the surface of the first insulating film 13b located at the interfaces of the first insulating film 13 and the substrate 10 is irradiated with the laser light LSR. The band-gap energy of the first insulating film 13b is smaller than the energy of the laser light LSR. Accordingly, the laser light LSR that has passed through the substrate 10 is absorbed by the first insulating film 13b. The absorption of the laser light LSR causes the SiN component in the first insulating film 13b to be thermally decomposed in a manner shown in the following reaction formula, for example.

$$SiN \rightarrow Si + (1/2) N_2 \uparrow$$

Consequently, as shown in FIG. 9, the first insulating film 13b does not adhere to the substrate 10, and thus the substrate 10 is removed easily.

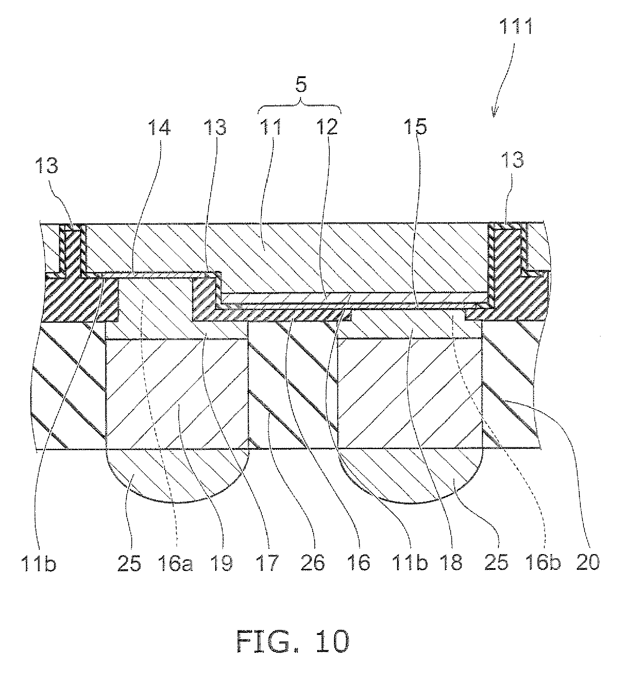

After that, as shown in FIG. 10, the surface of the resin 26 is ground until the end surfaces of the n-side metal pillar 19 and the p-side metal pillar 20 are exposed. Then, if necessary, external terminals 25, such as solder balls or metal bumps, are provided on the exposed end surfaces. A light-emitting device 111 is thus completed.

In the method for manufacturing the light-emitting device 111, there is no limit to the thickness of the first insulating film 13, so that the semiconductor layer 5 can be reliably protected by the first insulating film 13. In addition, at the laser lift off, the substrate 10 can be removed easily without allowing the first insulating film 13 to adhere to the substrate 10.

Second Embodiment

Subsequently, description will be given of a method for manufacturing a light-emitting device according to a second embodiment.

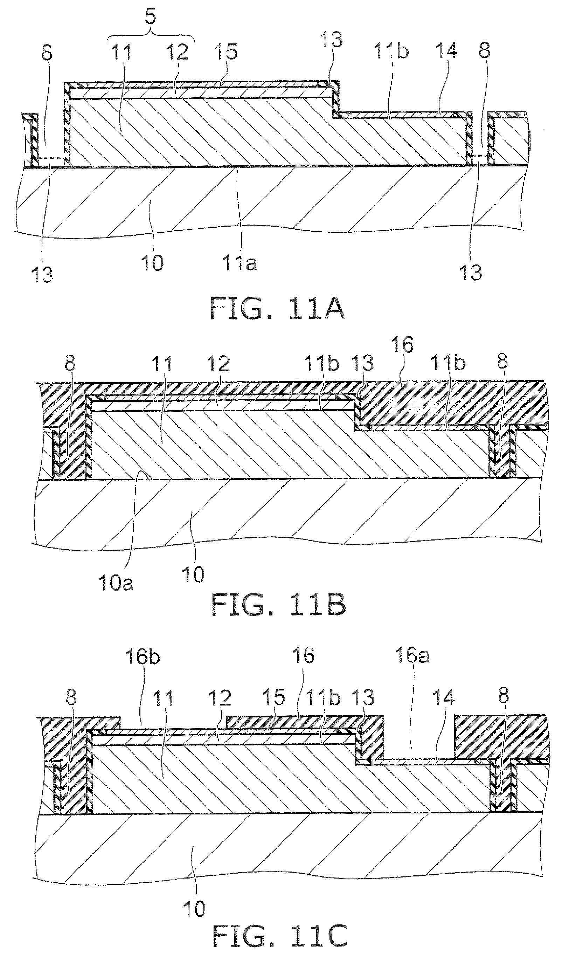

FIG. 11A to 13 are schematic cross-sectional views describing sequentially the method for manufacturing a light-emitting device according to the second embodiment.

In this embodiment, the processes from the formation of the first semiconductor layer 11 and the second semiconductor layer 12 until the formation of the first insulating film 13 are similar to those shown in FIGS. 3A to 3C.

In this embodiment, after the formation of the first insulating film 13, the first insulating film 13 formed in the bottom portions of the grooves 8 are removed as shown in FIG 11A. The first insulating film 13 is made, for example, of silicon oxide ($SiO_2$) or silicon nitride (SiN). If the first insulating film 13 is made of silicon oxide ($SiO_2$), the thickness t of the first insulating film 13 is smaller than the wavelength of the laser light LSR. If the first insulating film 13 is made of silicon nitride (SiN), there is no limit to the thickness t.

The first insulating film 13 in the bottom portions of the grooves 8 is removed in the same process where openings for forming the n-side electrode 14 and the p-side electrode 15 are formed. The first insulating film 13 is selectively removed by etching with, for example, a solution of hydrofluoric acid. The first insulating film 13 in the bottom portions of the grooves 8 is removed until the first main surface 10a of the substrate 10 is exposed.

Subsequently, as shown in FIG. 11B, the second insulating film 16 covering the n-side electrode 14, the p-side electrode 15, and the first insulating film 13 is formed. In addition, the second insulating film 16 is buried into the grooves 8. The second insulating film 16 is buried into the grooves 8 until coming into contact with the first main surface 10a of the substrate 10. The second insulating film 16 is made, for example, of polyimide.

After the formation of the second insulating film 16, the opening 16a that reaches the n-side electrode 14 and the opening 16b that reaches the p-side electrode 15 are formed in the second insulating film 16 as shown in FIG. 11C with, for example, a solution of hydrofluoric acid.

After that, the formation of the n-side metal pillar 19 and the p-side metal pillar 20, the formation of the resin 26, and the removal of the substrate 10 by the laser lift off are performed in a similar manner to those in the case illustrated in FIGS. 5 to 6.

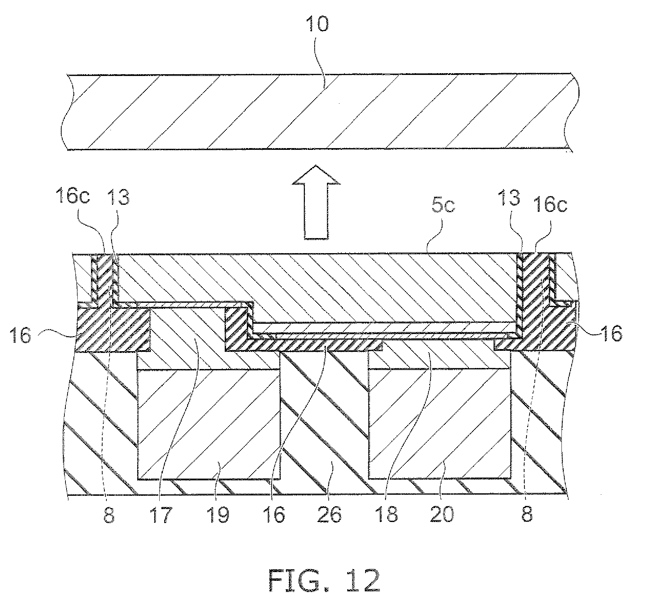

FIG. 12 illustrates a state where the substrate 10 has been removed by the laser lift off.

In this embodiment, since the first insulating film 13 in the bottom portions of the grooves 8 is removed in advance, the first insulating film 13 does not adhere to the substrate 10 at the laser lift off, and thus the substrate 10 is removed easily.

After the removal of the substrate 10, the lower surface 5c of the semiconductor layer 5 and a lower surface 16c of the second insulating film 16 appear as flat surfaces.

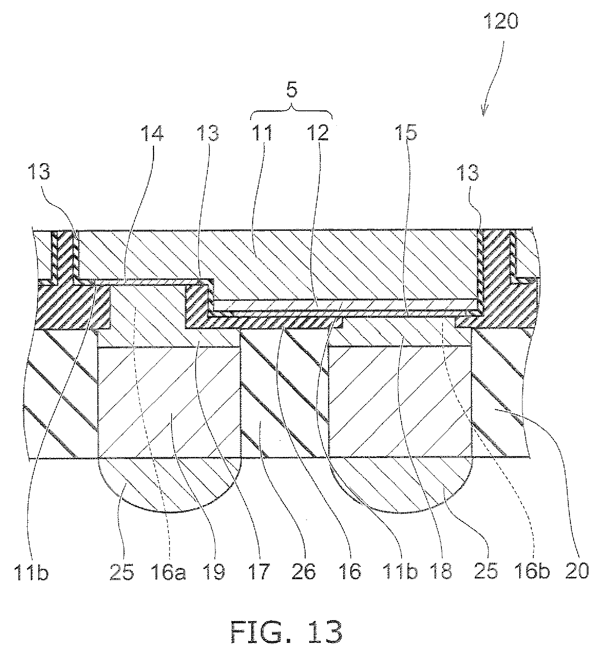

After that, as shown in FIG. 13, the surface of the resin 26 is ground until the end surfaces of the n-side metal pillar 19 and the p-side metal pillar 20 are exposed. Then, if necessary, external terminals 25, such as solder balls or metal bumps, are provided on the exposed end surfaces. A light-emitting device 120 is thus completed.

According to the method for manufacturing the light-emitting device 120, the first insulating film 13 being in contact with the substrate 10 has been removed in advance, so that the substrate 10 can be removed from the lower surface 5c of the semiconductor layer 5 easily at the laser lift off.

Third Embodiment

Subsequently, description will be given of a method for manufacturing a light-emitting device according to a third embodiment.

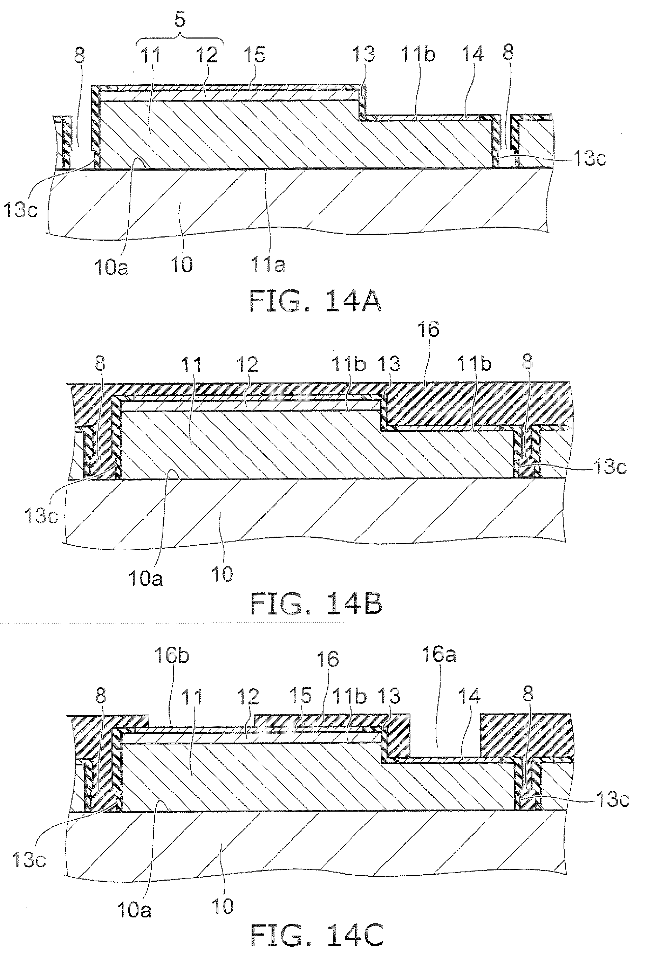

FIGS. 14A to 16 are schematic cross-sectional views describing sequentially the method for manufacturing a light-emitting device according to the third embodiment.

In this embodiment, the processes from the formation of the first semiconductor layer 11 and the second semiconductor layer 12 until the formation of the first insulating film 13 are similar to those shown in FIGS. 3A to 3C.

In this embodiment, after the formation of the first insulating film 13, the first insulating film 13 formed in the bottom portions of the grooves 8 is removed as shown in FIG 14A. In addition, portions of the first insulating film 13 near the bottom portions of the grooves 8 are also removed, and thus thinly-formed portions 13c are provided.

In this embodiment, the first insulating film 13 is made of silicon oxide ($SiO_2$). In the portions other than the thinly-formed portions 13c, the thickness of the first insulating film 13 is equal to or larger than the wavelength of the laser light LSR. In contrast, the thickness of each of the thinly-formed portions 13c is smaller than the wavelength of the laser light LSR. To put it differently, only parts (the portions 13c) of the first insulating film 13 formed on the side surfaces 5b of the semiconductor layer 5 have a thickness that is smaller than the wavelength of the laser light LSR.

In this embodiment, as shown in FIG. 14A, when the first insulating film 13 in the bottom portions of the grooves 8 is removed, only the portions of the first insulating film 13 near the bottom portions are etched by a larger amount than the etched amount for the other portions by taking the etching rate into consideration. Thus, the thickness of each of the residual portions 13c left after the etching is made smaller than the wavelength of the laser light LSR.

Subsequently, as shown in FIG. 14B, the second insulating film 16 to cover the n-side electrode 14, the p-side electrode 15, and the first insulating film 13 is formed. In addition, the second insulating film 16 is buried into the grooves 8. The second insulating film 16 is buried into the grooves 8 until coming into contact with the first main surface 10a of the substrate 10. The second insulating film 16 is made, for example, of silicon nitride, silicon oxide, or a resin such as polyimide.

After the formation of the second insulating film 16, the opening 16a that reaches the n-side electrode 14 and the opening 16b that reaches the p-side electrode 15 are formed in the second insulating film 16 as shown in FIG. 14C with, for example, a solution of hydrofluoric acid.

After that, the formation of the n-side metal pillar 19 and the p-side metal pillar 20, the formation of the resin 26, and the removal of the substrate 10 by the laser lift off are performed in a similar manner to those in the case illustrated in FIGS. 5A to 6B.

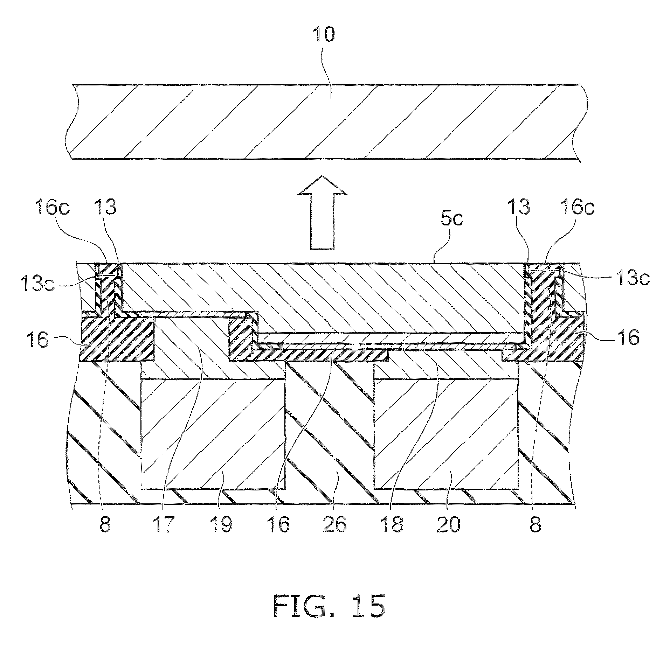

FIG. 15 illustrates a state where the substrate 10 has been removed by the laser lift off.

In this embodiment, since each of the portions 13c of the first insulating film 13 near the bottom portions of the grooves 8 is formed to have a thickness that is smaller than the wavelength of the laser light LSR, the advancing of the laser light LSR thrown upon from the side of the lower surface 5c of the semiconductor layer 5 is suppressed by the portions 13c.

Accordingly, the degradation of the semiconductor layer 5, especially, the degradation of the light-emitting layer of the second semiconductor layer 12 is avoided. Consequently, stable light-emitting characteristics can be maintained. In addition, removal of the first insulating film 13 is prevented from occurring at the interface between each of the side surfaces 5b of the semiconductor layer 5 and the first insulating film 13.

In addition, the effects of the irradiation of the laser light LSR on the second insulating film 16 that is in contact with the first insulating film 13 near the side surfaces 5b, such as the melting of the second insulating film 16, is reduced. Consequently, the lowering of the reliability can be suppressed. In addition, the first insulating film 13 in the bottom portions of the grooves 8 has been removed in advance, so that the the first insulating film 13 does not adhere to the substrate 10 at the laser lift off, and thus the substrate 10 is removed easily.

After the removal of the substrate 10, the lower surface 5c of the semiconductor layer 5 and a bottom surface 16c of the second insulating film 16 appear as flat surfaces.

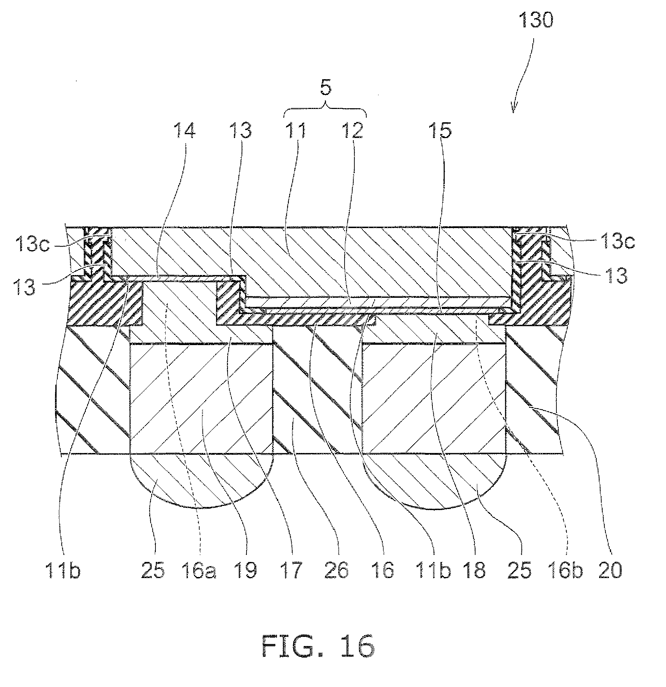

After that, as shown in FIG. 16, the surface of the resin 26 is ground until the end surfaces of the n-side metal pillar 19 and the p-side metal pillar 20 are exposed. Then, if necessary, external terminals 25, such as solder balls or metal bumps, are provided on the exposed end surfaces. A light-emitting device 130 is thus completed.

In this embodiment, the portions 13c that are thinner than the wavelength of the laser light LSR are provided near the bottom portions of the grooves 8, but similar effects can be obtained if such portions 13c are provided between the first main surface 10a of the substrate 10 and the light-emitting layer of the second semiconductor layer 12.

Fourth Embodiment

Subsequently, description will be given of a light-emitting device according to a fourth embodiment.

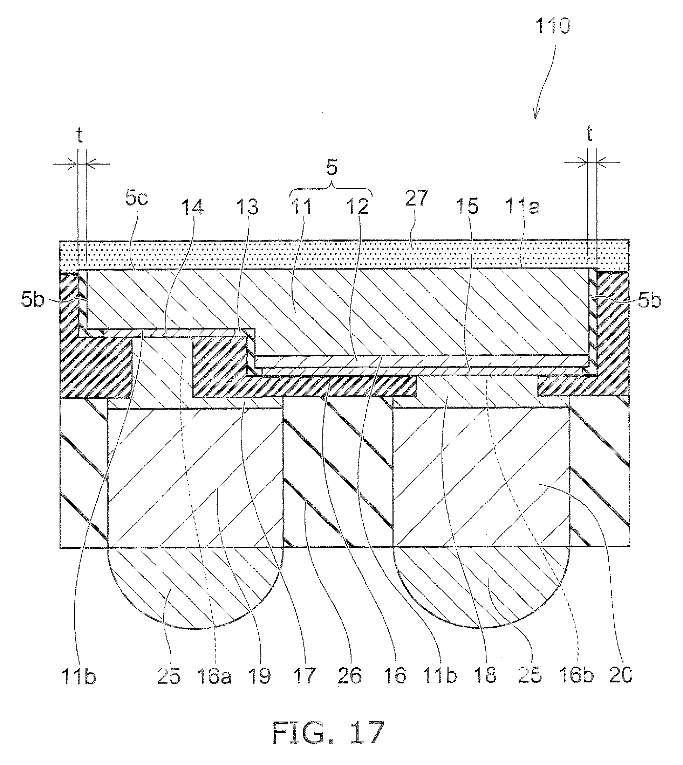

FIG. 17 is a schematic cross-sectional view illustrating the light-emitting device according to the fourth embodiment.

A light-emitting device 110 according to this embodiment includes: the semiconductor layer 5 including a light-emitting layer, and formed by using the substrate 10 as a supporting body, the substrate 10 being removed from the semiconductor layer 5 by irradiation of the laser-light performed after the formation of the semiconductor layer 5; the n-side electrode 14 (first electrode portion) and the p-side electrode 15 (second electrode portion) provided on the top surface 5a of the semiconductor layer 5 on the opposite side to the lower surface 5c that are irradiated with the laser light; the first insulating film 13 covering at least the side surfaces 5b of the semiconductor layer 5; and the second insulating film 16 covering the first insulating film 13. The second insulating film 16 (irrespective of silicon nitride or a resin) and the semiconductor layer 5 absorb the laser light. Alternatively, both the band-gap energy of the second insulating film 16 and the band-gap energy of the semiconductor layer 5 are made smaller than the energy of the laser light described above.

In addition, the portions of the first insulating film 13 covering the side surfaces 5b of the semiconductor layer 5 suppress the advancing of the laser light so that the laser light can be prevented from reaching the light-emitting layer in the side surfaces 5b from the lower surface 5c of the semiconductor layer 5.

In the light-emitting device 110, the first insulating film 13 is provided on the side surfaces 5b of the semiconductor layer 5 to have the thickness t smaller than the wavelength of the laser light LSR thrown upon at the laser lift off to remove the substrate 10 from the semiconductor layer 5.

The laser light to be used is, for example, light of ArF laser (wavelength: 193 nm), light of KrF laser (wavelength: 248 nm), light of XeCl laser (wavelength: 308 nm), or light of XeF laser (wavelength: 353 nm). The first insulating film 13 is formed to have the thickness t smaller than the wavelength of the laser light that is to be used actually.

According to the light-emitting device 110 that has the first insulating film 13 with the above-described thickness, the laser light LSR thrown upon at the laser lift off does not enter the first insulating film 13 formed on the side surfaces 5b of the semiconductor layer 5. Accordingly, the degradation of the semiconductor layer 5, especially, that of the light-emitting layer of the second semiconductor layer 12, is avoided. Consequently, stable light-emitting characteristics can be maintained. In addition, removal of the first insulating film 13 is prevented from occurring at the interface between each of the side surfaces 5b of the semiconductor layer 5 and the first insulating film 13. In addition, the adverse effects of the irradiation of the laser light LSR on the second insulating film 16 that is in contact with the first insulating film 13 near the side surfaces 5b, such as the melting of the second insulating film 16, is reduced. Consequently, the lowering of the reliability is suppressed.

The light-emitting device 110 according to this embodiment is formed collectively in a wafer configuration by the above-described manufacturing method according to the first embodiment. The semiconductor layer 5 includes the first semiconductor layer 11 and the second semiconductor layer 12. The first semiconductor layer 11 is, for example, an n type GaN layer, and serves as a current pathway in the lateral direction. The conductivity type of the first semiconductor layer 11 is not limited to n type but may be p type.

In the light-emitting device 110, light is emitted out mainly from the first main surface 11a of the first semiconductor layer 11 (i.e., the lower surface 5c of the semiconductor layer 5). The second semiconductor layer 12 is provided on the second main surface 11b of the first semiconductor layer 11 on the opposite side to the first main surface 11a.

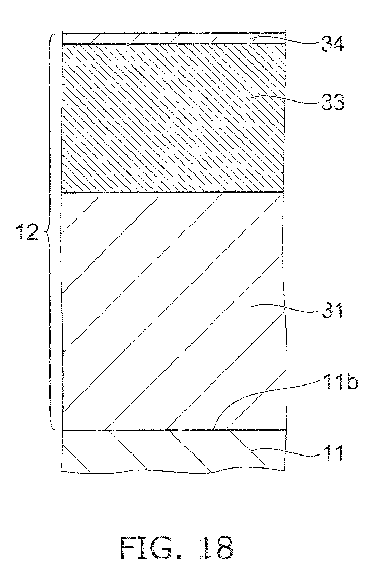

The second semiconductor layer 12 has a laminate structure of multiple semiconductor layers, each of the semiconductor layers including a light-emitting layer (active layer). FIG. 18 shows an example of the laminate structure. Note that FIG. 18 shows an upside-down image of FIG. 17.

An n type GaN layer 31 is provided on the second main surface 11b of the first semiconductor layer 11. A light-emitting layer 33 is provided on the GaN layer 31. The light-emitting layer 33 has a multiple quantum well structure containing, for example, InGaN. A p type GaN layer 34 is provided on the light-emitting layer 33.

As shown in FIG. 17, a projected portion and a recessed portion are provided on the second main surface 11b side of the first semiconductor layer 11. The second semiconductor layer 12 is provided on the surface of the projected portion. Accordingly, the projected portion includes a laminate structure of the first semiconductor layer 11 and the second semiconductor layer 12.

The bottom surface of the recessed portion is the second main surface 11b of the first semiconductor layer 11. The n-side electrode 14 is provided on the second main surface 11b of the recessed portion as a first electrode.

The p-side electrode 15 is provided on the opposite surface of the second semiconductor layer 12 to the surface being in contact with the first semiconductor layer as a second electrode.

The second main surface 11b of the first semiconductor layer 11 is covered with the first insulating film 13 made, for example, of silicon oxide. The portions of the first insulating film 13 covering the side surfaces 5b of the semiconductor layer 5 reach the first main surface 11a of the first semiconductor layer 11. The n-side electrode 14 and the p-side electrode 15 are exposed from the first insulating film 13. The n-side electrode 14 and the p-side electrode 15 are insulated from each other by the first insulating film 13, and thus are provided as electrodes that are electrically independent of each other. In addition, the first insulating film 13 covers also the side surfaces of the projected portion including the second semiconductor layer 12.

The second insulating film 16 is provided on the second main surface 11b side so as to cover the first insulating film 13, a part of the n-side electrode 14, and a part of the p-side electrode 15. The second insulating film 16 is , for example, made of silicon oxide or a resin.

The opposite surface of the second insulating film 16 to the first semiconductor layer 11 and the second semiconductor layer 12 is flattened, and the n-side interconnection 17 as a first interconnection and the p-side interconnection 18 as a second interconnection are provided on the flattened surface.

The n-side interconnection 17 is also provided in the opening 16a, which is formed in the second insulating film 16 so as to reach the n-side electrode 14, and the n-side interconnection 17 is electrically connected to the n-side electrode 14. The p-side interconnection 18 is also provided in the opening 16b, which is formed in the second insulating film 16 so as to reach the p-side electrode 15, and the p-side interconnection 18 is electrically connected to the p-side electrode 15.

All of the n-side electrode 14, the p-side electrode 15, the n-side interconnection 17, and the p-side interconnection 18 are provided on the second main surface 11b side of the first semiconductor layer and form interconnect layers to supply a current to the light-emitting layer.

The n-side metal pillar 19 is provided on the opposite surface of the n-side interconnection 17 to the n-side electrode 14 as a first metal pillar. The p-side metal pillar 20 is provided on the opposite surface of the p-side interconnection 18 as a second metal pillar. The resin (third insulating film) 26 covers the portion around the n-side metal pillar 19, the portion around the p-side metal pillar 20, the n-side interconnection 17, and the p-side interconnection 18. In addition, the resin 26 covers side surfaces 11c of the first semiconductor layer 11 as well, and thus the side surfaces 11c of the first semiconductor layer 11 are protected by the resin 26.

The first semiconductor layer 11 is electrically connected to the n-side metal pillar 19 via the n-side electrode 14 and the n-side interconnection 17. The second semiconductor layer 12 is electrically connected to the p-side metal pillar 20 via the p-side electrode 15 and the p-side interconnection 18. The external terminals 25, such as solder balls or metal bumps, are provided on the lower end surfaces, exposed from the resin 26, of the n-side metal pillar 19 and of the p-side metal pillar 20. The light-emitting device 110 is electrically connected to an external circuit through the external terminals 25.

The thickness of the n-side metal pillar 19 (the thickness in the vertical direction of FIG. 17) is larger than the thickness of the laminate including the semiconductor layer 5, the n-side electrode 14, the p-side electrode 15, the insulating films 13 and 16, the n-side interconnection 17, and the p-side interconnection 18. Likewise, the thickness of the p-side metal pillar 20 is also larger than the thickness of the laminate described above. If these conditions are satisfied, the aspect ratio (the ratio of the thickness to the planar size) of each of the metal pillars 19 and 20 does not have to be equal to or larger than 1, but may be smaller than 1. Specifically, the thickness of each of the meal pillars 19 and 20 may be smaller than the planar size thereof.

According to the structure of this embodiment, even if the semiconductor layer 5 is thin, a certain mechanical strength can be secured by making the n-side metal pillar 19, the p-side metal pillar 20, and the resin 26 thicker. In addition, when the light-emitting device 110 is mounted on a circuit board or the like, the stress applied to the semiconductor layer 5 through the external terminals 25 can be absorbed by the n-side metal pillar 19 and the p-side metal pillar 20. Accordingly, the stress applied to the semiconductor layer 5 can be reduced. The resin 26 to reinforce the n-side metal pillar 19 and the p-side metal pillar 20 is preferably made of a resin whose coefficient of thermal expansion is equal to, or close to, that of the circuit board or the like. Such a resin 26 is, for example, an epoxy resin, a silicone resin, or a fluorine resin. In addition, the resin 26 is colored in black, for example. The resin 26 thus prevents the internal light from leaking out and prevents unnecessary external light from entering.

The n-side interconnection 17, the p-side interconnection 18, the n-side metal pillar 19, and the p-side metal pillar 20 are made, for example, of copper, gold, nickel, or silver. Of these materials, copper is preferable because of its favorable thermal conductivity, its high electromigration resistance, and its excellent adherence to the insulating films.

A phosphor layer 27 is provided on the light-emitting surface of the light-emitting device 110 when necessary. For example, if the light-emitting layer emits blue light and the blue light is emitted from the light-emitting device 110 as it is, no such phosphor layer 27 is necessary. In contrast, if the light-emitting device 110 emits white light or the like, that is, light of a wavelength different from that of the light emitted by the light-emitting layer, the phosphor layer 27 is provided which contains phosphors absorbing the wavelength of the light emitted by the light-emitting layer and thus converting wavelength of the light emitted by the light-emitting layer into the wavelength of the light to be emitted from the light-emitting device 110.

The light-emitting surface of the light-emitting device 110 may be provided with a lens (not illustrated) when necessary. Lenses of various shapes, such as convex lenses, concave lenses, aspheric lenses, may be used. The number and the positions of the lenses to be provided may be determined appropriately.

In the light-emitting device 110 according to this embodiment, the degradation of the semiconductor layer 5 is avoided, and removal of the first insulating film 13, the melting of the second insulating film 16, and the like are reduced. Accordingly, light-emitting characteristics of the light-emitting device 110 is secured and the lowering of the reliability of the light-emitting device 110 is reduced.

Fifth Embodiment

Subsequently, description will be given of a light-emitting device according to a fifth embodiment.

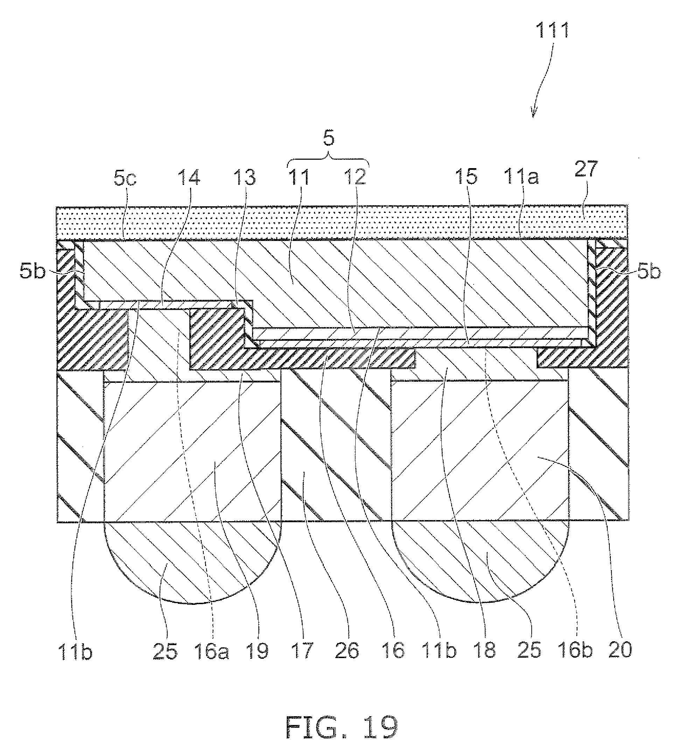

FIG. 19 is a schematic cross-sectional view illustrating the light-emitting device according to the fifth embodiment.

As shown in FIG. 19, a light-emitting device 111 according to the fifth embodiment includes the first insulating film 13 made of a material that has smaller band-gap energy than the energy of the laser light LSR.

The light-emitting device 111 according to the fifth embodiment is formed collectively in a wafer configuration by another example of the above-described manufacturing method according to the first embodiment. If, for example, light of KrF laser (wavelength: 248 nm) is used as the laser light LSR at the laser lift off, the first insulating film 13 is made, for example, of silicon nitride (SiN). In other cases, the first insulating film 13 is made of a material containing a nitride. If the band-gap energy of the first insulating film 13 is smaller than the energy of the laser light LSR, the transmissibility of the laser light LSR drops significantly. Consequently, the entry, into the first insulating film 13, of the laser light LSR thrown upon at the laser lift off is suppressed.

In the light-emitting device 111 according to this embodiment, the degradation of the semiconductor layer 5 is avoided, and removal of the first insulating film 13, the melting of the second insulating film 16, and the like are reduced. Accordingly, light-emitting characteristics of the light-emitting device 111 is secured and the lowering of the reliability of the light-emitting device 111 is reduced.

Sixth Embodiment

Subsequently, description will be given of a light-emitting device according to a sixth embodiment.

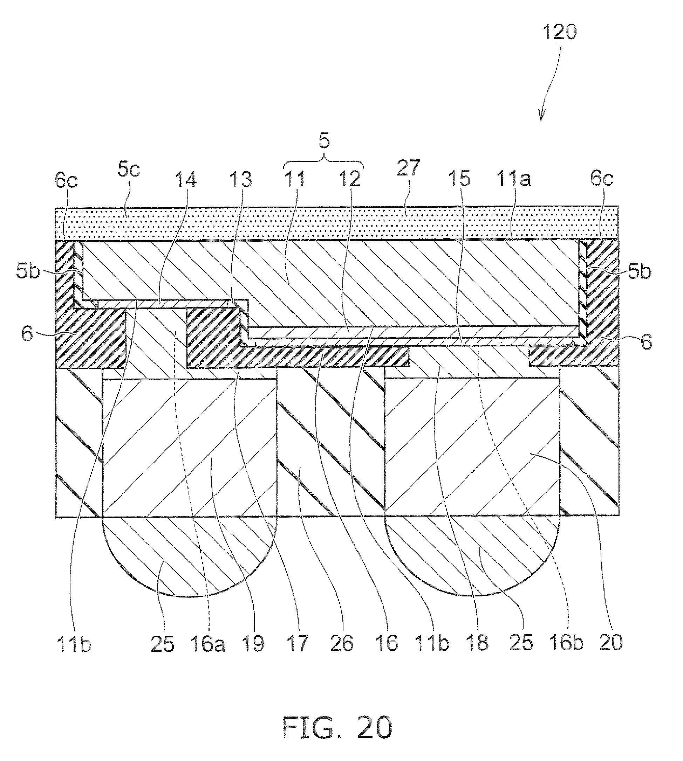

FIG. 20 is a schematic cross-sectional view illustrating the light-emitting device according to the sixth embodiment.

As shown in FIG. 20, a light-emitting device 120 according to the sixth embodiment differs from the light-emitting device 111 shown in FIG. 19 in that the first insulating film 13 of the light-emitting device 120 is not provided in the surrounding areas of the semiconductor layer 5.

The light-emitting device 120 according to the sixth embodiment is formed collectively in a wafer configuration by the above-described manufacturing method according to the second embodiment.

The first insulating film 13 is made, for example, of silicon oxide ($SiO_2$) or silicon nitride (SiN). If the first insulating film 13 is made of silicon oxide ($SiO_2$), the first insulating film 13 is formed to have the thickness t smaller than the wavelength of the laser light LSR. If the first insulating film 13 is made of silicon nitride (SiN), there is no limit to the thickness t.

In the light-emitting device 120 according to the sixth embodiment, portions of the first insulating film 13 in the surrounding areas of the semiconductor layer 5 are removed, so that the first insulating film 13 does not adhere to the substrate 10 at the laser lift off, and the substrate 10 is thus removed easily.

In addition, after the removal of the substrate 10, the lower surface 5c of the semiconductor layer 5 and the lower surface 16c of the second insulating film 16 appear as flat surfaces.

Seventh Embodiment

Subsequently, description will be given of a light-emitting device according to a seventh embodiment.

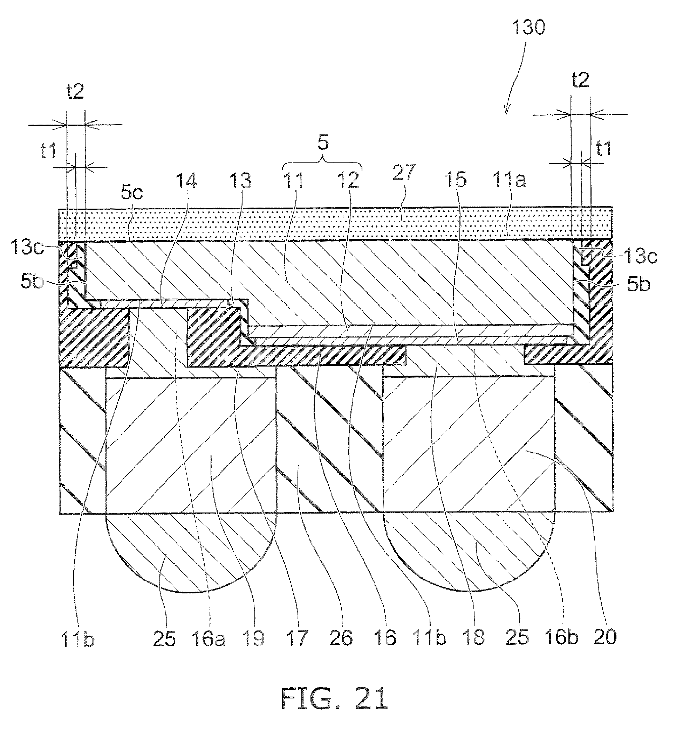

FIG. 21 is a schematic cross-sectional view illustrating the light-emitting device according to the seventh embodiment.

As shown in FIG. 21, in a light-emitting device 130 according to the seventh embodiment, thinner portions 13c are provided as portions of the first insulating film 13 that cover the side surfaces 5b of the semiconductor layer 5.

The light-emitting device 130 according to the seventh embodiment is formed collectively in a wafer configuration by the above-described manufacturing method according to the third embodiment.

Each of the thinner portions 13c of the first insulating film 13 is provided between the bottom surface 5c of the semiconductor layer 5 and the light-emitting layer provided in the second semiconductor layer 12. The thickness t1 of each of the portions 13c is smaller than the wavelength of the laser light LSR. In contrast, the other portions of the first insulating film 13 have a thickness t2 that is equal to or larger than the wavelength of the laser light LSR.

In this embodiment, since the portions 13c are formed so thinly that the thickness of each of the portions 13c is smaller than the wavelength of the laser light LSR, the advancing of the laser light LSR thrown upon from the side of the lower surface 5c of the semiconductor layer 5 is suppressed by the portions 13c. Accordingly, the degradation of the semiconductor layer 5 is avoided, and removal of the first insulating film 13, the melting of the second insulating film 16, and the like are reduced. Accordingly, light-emitting characteristics of the light-emitting device 130 is secured and the lowering of the reliability of the light-emitting device 130 is reduced.

According to the embodiments thus far described, in the manufacturing of the light-emitting devices 110, 111, 120, and 130 employing the laser lift off, the advancing of the laser light LSR within the first insulating film 13 that cover the side surfaces 5b of the semiconductor layer 5 can be suppressed. Accordingly, effects of the irradiation of the laser light LSR on such as the degradation of the semiconductor layer 5, the removal of the first insulating film 13, and the melting of the second insulating film 16, can be reduced. Consequently, improvements in the operational stability and the reliability of the light-emitting devices 110, 111, 120, and 130 can be accomplished.

Hereinabove, some embodiments have been described with reference to specific examples. The above-described embodiments are not limited thereto. For example, from the aforementioned embodiments and variations, those skilled in the art may make different modes of embodiments by providing any additional constituent element or by omitting any constituent element, based on modified design, or by appropriately combining characteristic features in the above embodiments. These different modes of embodiments are also included in the scope of the invention as long as the modes retain the gist of the invention. In addition, those skilled in the art may make various kinds of changes in design concerning the substrate, the semiconductor layers, the electrodes, the interconnections, the metal pillars, the insulating films, the material of the resin, the size, the shape, the layout, and the like. Those thus changed are also included in the scope of the invention unless the changes depart from the gist of the invention.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

**Claims**

1. A method for manufacturing a light-emitting device (110, 111, 120, 130) comprising:

   removing a substrate (10) from a semiconductor layer (5), the semiconductor layer (5) being provided on a first main surface (10a) of the substrate (10), the semiconductor layer (5) including a light-emitting layer (33), at least a top surface (5a) and side surfaces (5b) of the semiconductor layer (5) being covered with a first insulating film (13), a first electrode portion (14) electrically continuous to the semiconductor layer (5) being provided, a second electrode portion (15) electrically continuous to the semiconductor layer (5) being provided, the first insulating film (13) being covered with a second insulating film (16), the removing being performed by irradiating the semiconductor layer (5) with laser light (LSR) from a side of a second main surface (10b) of the substrate (10), the second main surface (10b) being opposite to the first main surface (10a),

each of band-gap energy of the second insulating film (16) and band-gap energy of the semiconductor layer (5) being smaller than energy of the laser light (LSR).

2. The method according to claim 1, wherein at least a part of the portions of the first insulating film (13) covering the side surfaces (5b) between the first main surface (10a) and the light-emitting layer (33) is formed to have a smaller thickness than a wavelength of the laser light (LSR) in a direction perpendicular to the side surfaces (5b).

3. The method according to claim 2, wherein the wavelength of the laser light (LSR) is 248 nm and the thickness of the part of the first insulating film (13) is smaller than 248 nm.

4. The method according to any of claims 1-3, wherein the first insulating film (13) contains silicon oxide.

5. The method according to any of claims 1-4, wherein band-gap energy of the first insulating film (13) is smaller than the energy of the laser light (LSR).

6. The method according to any of claims 1-5, wherein the first insulating film (13) contains silicon nitride.

7. The method according to any of claims 1-6, wherein the portions of the first insulating film (13) covering the side surfaces (5b) of the semiconductor layer (5) reach the first main surface (10a) of the substrate (10).

8. The method according to any of claims 1-7, wherein the second insulating film (16) and the semiconductor layer (5) absorb the laser light (LSR).

9. The method according to any of claims 1-8, wherein a portion of the first insulating film (13) being in contact with the substrate (10) is removed after forming the first insulating film (13) and before throwing the laser light (LSR) upon.

10. The method according to any of claims 1-9, wherein the laser light (LSR) does not reach a depth position of the light-emitting layer (33) within portions of the first insulating film (13) covering the side surfaces (5b) of the semiconductor layer (5).

11. A light-emitting device (110, 111, 120, 130) comprising:

a semiconductor layer (5) including a light-emitting layer (33);
a first electrode portion (14) and a second electrode portion (15) which are provided on a second main surface (11b) of the semiconductor layer (5), the second main surface (11b) being opposite to a first main surface (11a) of the semiconductor layer (5);
a first insulating film (13) covering at least side surfaces (5b) of the semiconductor layer (5); and
a second insulating film (16) covering the first insulating film (13),
a thickness of a part of the first insulating film (13) being smaller than 248 nm,
the second insulating film (16) and the semiconductor layer (5) being made of materials which absorb a laser light (LSR) having a wavelength longer than 248 nm.

12. The device (110, 111, 120, 130) according to claim 11, wherein at least a part of the portions of the first insulating film (13) covering the side surfaces (5b) between the first main surface (11a) and the light-emitting layer (33) has a smaller thickness than a wavelength of the laser light (LSR) in a direction perpendicular to the side surfaces (5b).

13. The device (110, 111, 120, 130) according to any of claims 11 and 12, wherein portions of the first insulating film (13) that cover the side surfaces (5b) of the semiconductor layer (5) suppress the laser light (LSR) from reaching a depth position of the light-emitting layer (33) from the first main surface (11a) side of the semiconductor layer (5).

14. The device (110, 111, 120, 130) according to any of claims 11-13, wherein the first insulating film (13) contains silicon oxide.

**15.** The device (110, 111, 120, 130) according to any of claims 11-14, wherein the first insulating film (13) is made of a material with band-gap energy smaller than the energy of the laser light (LSR).

**16.** The device (110, 111, 120, 130) according to any of claims 11-15, wherein the first insulating film (13) contains silicon nitride.

**17.** The device (110, 111, 120, 130) according to any of claims 11-16, wherein the portions of the first insulating film (13) covering the side surfaces (5b) of the semiconductor layer (5) reach the first main surface (10a) of the substrate (10).

**18.** The device (110, 111, 120, 130) according to any of claims 11-17, further comprising:

the second insulating film (16) covering the first insulating film (13);
a first interconnection (17) piercing the second insulating film (16) and electrically contact with the first electrode portion (14); and
a second interconnection (18) piercing the second insulating film (16) and electrically contact with the second electrode portion (15).

**19.** The device (110, 111, 120, 130) according to claim 18, further comprising:

a third insulating film (26) provided on the second insulating film (16);
a first metal pillar (19) piercing the third insulating film (26) and electrically contact with the first interconnection (17); and
a second metal pillar (20) piercing the third insulating film (26) and electrically contact with the second interconnection (18).

FIG. 1

FIG. 2

FIG. 3A

FIG. 3B

FIG. 3C

FIG. 4A

FIG. 4B

FIG. 4C

FIG. 5A

FIG. 5B

FIG. 6A

LSR

FIG. 6B

FIG. 7

FIG. 8

FIG. 9

FIG. 10

FIG. 11A

FIG. 11B

FIG. 11C

FIG. 12

FIG. 13

FIG. 14A

FIG. 14B

FIG. 14C

FIG. 15

130

5

14  13  11  12  15

13c

13

13c

13

11b  25  16a  19  17  26  16  11b  18  25  16b  20

FIG. 16

FIG. 17

FIG. 18

FIG. 19

FIG. 20

FIG. 21

**EUROPEAN SEARCH REPORT**

Application Number

EP 10 17 8705

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2008/210955 A1 (UEMURA TOSHIYA [JP] ET AL) 4 September 2008 (2008-09-04) | 1-4,7,8, 10, 12-14,17 | INV. H01L33/00 H01L33/44 |
| Y | * paragraphs [0002] - [0004], [0 11], [0 19]; figure 1 * <br> * paragraphs [0051] - [0060]; figure 1 * | 5,6,9, 15,16 | |
| Y | US 2006/246687 A1 (KAISER STEPHAN [DE] ET AL) 2 November 2006 (2006-11-02) * paragraph [0065]; figure 3 * | 5,6,15, 16 | |
| Y | US 2008/149953 A1 (ANDO MASANOBU [JP] ET AL) 26 June 2008 (2008-06-26) * paragraph [0081]; figures 1B-1E * | 9 | |
| A | US 2009/014747 A1 (SHIUE CHING-CHUAN [TW] ET AL) 15 January 2009 (2009-01-15) * paragraphs [0042] - [0044] * | 5,6,15, 16 | |
| A | WO 2006/043796 A1 (SEOUL OPTO DEVICE CO LTD [KR]; POSTECH FOUNDATION [KR]; LEE JONG LAM [ ]) 27 April 2006 (2006-04-27) * paragraphs [0116] - [0121]; figures 59-66 * | 1,11 | TECHNICAL FIELDS SEARCHED (IPC) <br> H01L |
| Y | US 2009/200568 A1 (HORIE HIDEYOSHI [JP]) 13 August 2009 (2009-08-13) * paragraph [0641]; figures 4-1-4-3 * <br> * paragraphs [0009] - [0024], [0 30] * <br> * paragraphs [0758], [ 786]; figures 5-1 * <br> * paragraphs [0807] - [0812] * <br> * paragraphs [0940], [ 970] * | 11,18,19 | |
| Y | US 2009/101929 A1 (MO QINGWEI [US] ET AL) 23 April 2009 (2009-04-23) * paragraphs [0037], [0 38]; figures 6-8 * | 11,18,19 | |

-/--

The present search report has been drawn up for all claims

| Place of search | Date of completion of the search | Examiner |
|---|---|---|
| The Hague | 3 August 2011 | Müller-Kirsch, Lutz |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

Application Number

EP 10 17 8705

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2006/081869 A1 (LU CHI-WEI [TW] ET AL) 20 April 2006 (2006-04-20) * paragraph [0047]; figures 6,8 * ----- | 11 | |
| A | US 2006/278885 A1 (TAIN RA-MIN [TW] ET AL) 14 December 2006 (2006-12-14) * paragraphs [0013], [0 14], [0 23], [0024], [0 26]; figure 2 * ----- | 19 | |

TECHNICAL FIELDS
SEARCHED      (IPC)

The present search report has been drawn up for all claims

| Place of search | Date of completion of the search | Examiner |
|---|---|---|
| The Hague | 3 August 2011 | Müller-Kirsch, Lutz |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

  .................................................................................
& : member of the same patent family, corresponding
   document

EPO FORM 1503 03.82 (P04C01)

Europäisches
Patentamt

European
Patent Office

Office européen
des brevets

**Application Number**

EP 10 17 8705

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

Application Number

EP 10 17 8705

The Search Division considers that the present European patent application does not comply with the
requirements of unity of invention and relates to several inventions or groups of inventions, namely:

    1. claims: 1-17

        Method and light emitting device having sidewall protection
        layers with a laser lift-off resistant design
                ---

    2. claims: 18, 19

        Surface mountable light emitting devices having flip chip
        design and particular electrical connection structure
                ---

## ANNEX TO THE EUROPEAN SEARCH REPORT
## ON EUROPEAN PATENT APPLICATION NO.

EP 10 17 8705

This annex lists the patent family members relating to the patent documents cited in the above-mentioned European search report.
The members are as contained in the European Patent Office EDP file on
The European Patent Office is in no way liable for these particulars which are merely given for the purpose of information.

03-08-2011

| Patent document cited in search report | | Publication date | Patent family member(s) | | Publication date |
|---|---|---|---|---|---|
| US 2008210955 | A1 | 04-09-2008 | JP | 2008186959 A | 14-08-2008 |
| US 2006246687 | A1 | 02-11-2006 | CN | 1745483 A | 08-03-2006 |
| | | | WO | 2004068572 A2 | 12-08-2004 |
| | | | EP | 1588414 A2 | 26-10-2005 |
| | | | JP | 4662918 B2 | 30-03-2011 |
| | | | JP | 2006518668 A | 17-08-2006 |
| | | | KR | 20060024763 A | 17-03-2006 |
| | | | TW | I247368 B | 11-01-2006 |
| US 2008149953 | A1 | 26-06-2008 | NONE | | |
| US 2009014747 | A1 | 15-01-2009 | NONE | | |
| WO 2006043796 | A1 | 27-04-2006 | CN | 101084583 A | 05-12-2007 |
| | | | EP | 1810351 A1 | 25-07-2007 |
| | | | JP | 2008518436 A | 29-05-2008 |
| | | | US | 2008006836 A1 | 10-01-2008 |
| | | | US | 2010124797 A1 | 20-05-2010 |
| | | | US | 2010213494 A1 | 26-08-2010 |
| | | | US | 2011169039 A1 | 14-07-2011 |
| US 2009200568 | A1 | 13-08-2009 | CN | 101512783 A | 19-08-2009 |
| | | | EP | 2023412 A1 | 11-02-2009 |
| | | | WO | 2007126094 A1 | 08-11-2007 |
| US 2009101929 | A1 | 23-04-2009 | CN | 101868863 A | 20-10-2010 |
| | | | EP | 2206165 A1 | 14-07-2010 |
| | | | WO | 2009053916 A1 | 30-04-2009 |
| | | | JP | 2011501428 A | 06-01-2011 |
| | | | KR | 20100085121 A | 28-07-2010 |
| US 2006081869 | A1 | 20-04-2006 | JP | 2006121084 A | 11-05-2006 |
| | | | KR | 20060054089 A | 22-05-2006 |
| | | | TW | I257714 B | 01-07-2006 |
| US 2006278885 | A1 | 14-12-2006 | NONE | | |

EPO FORM P0459

For more details about this annex : see Official Journal of the European Patent Office, No. 12/82